# EUROPÄISCHE PATENTSCHRIFT

(11) **EP 2 885 677 B1**
(45) Veröffentlichungstag und Bekanntmachung des Hinweises auf die Patenterteilung: **21.12.2016**
(21) Anmeldenummer: 13753263.6
(22) Anmeldetag: 12.07.2013
(51) Int. Cl.: G03F 7/20

(54) **VERFAHREN ZUR OPTISCHEN ÜBERTRAGUNG EINER STRUKTUR IN EIN AUFNAHMEMEDIUM**
METHOD FOR OPTICAL TRANSMISSION OF A STRUCTURE INTO A RECORDING MEDIUM
PROCÉDÉ DE TRANSFERT OPTIQUE D'UNE STRUCTURE DANS UN MILIEU D'ENREGISTREMENT

(30) Priorität: 16.08.2012 DE 102012016178
(43) Veröffentlichungstag der Anmeldung: 24.06.2015
(73) Patentinhaber: Forschungszentrum Jülich GmbH, 52425 Jülich (DE)
(72) Erfinder: HARDTDEGEN, Hilde, 52064 Aachen (DE); MIKULICS, Martin, 52428 Jülich (DE)
(86) Internationale Anmeldenummer: PCT/DE2013/000377
(87) Internationale Veröffentlichungsnummer: WO 2014/026662

(56) Entgegenhaltungen:
- US-A1- 2007 078 613
- YUAN Z ET AL: "Electrically driven single-photon source", SCIENCE, AMERICAN ASSOCIATION FOR THE ADVANCEMENT OF SCIENCE, WASHINGTON, DC; US, 4. Januar 2002 (2002-01-04), Seiten 102-105, XP002278163, ISSN: 0036-8075, DOI: 10.1126/SCIENCE.1066790

## Beschreibung

### Stand der Technik

Mikro- und Nanostrukturen werden meistens im Wege der optischen Lithographie gefertigt. Dabei wird das zu strukturierende Substrat zunächst mit einem Aufnahmemedium belegt. In dieses Aufnahmemedium wird die zu fertigende Struktur übertragen, indem das Aufnahmemedium durch eine Maske hindurch lokal mit Licht bestrahlt wird. Es wird hierdurch von einem unbeschriebenen in einen beschriebenen Zustand überführt, der sich in veränderten physikalischen und/oder chemischen Eigenschaften des Aufnahmemediums manifestiert. Anschließend wird das Aufnahmemedium entweder nur an den beschriebenen Stellen oder nur an den unbeschriebenen Stellen selektiv entfernt, woraufhin das Substrat an den freigelegten Stellen bearbeitet, etwa geätzt, werden kann.

Die minimale Größe der zu schreibenden Strukturen ist beugungsbedingt auf die Größenordnung der Lichtwellenlänge festgelegt. Um die Strukturen zu verkleinern, d.h. die Ortsauflösung zu verbessern, muss daher die verwendete Lichtwellenlänge immer weiter verringert werden. Die Notwendigkeit, bei jeder Änderung der Struktur aufs Neue zeitaufwändig und teuer eine neue Maske zu fertigen, schränkt den Praxisnutzen der optischen Lithographie speziell für die prototypische Fertigung neuer Strukturen ein.

Aus US 2007/078613 A1 ist ein Verfahren zur optischen Übertragung einer Struktur in ein Aufnahmemedium bekannt, welches durch Einstrahlung von Photonen aus einer Photonenquelle (nanoLED) lokal von einem ersten unbeschriebenen Zustand in einen zweiten beschriebenen Zustand überführbar ist, wobei sich die beiden Zustände des Aufnahmemediums in unterschiedlichen chemischen Eigenschaften des Aufnahmematerials manifestieren. Dabei werden Photonen mit einer Energie von 3,36 eV, eine typische Leistungsdichte von 100 W/cm² und ein typischer Abstand der Nanodrähte von 10 nm offenbart. Daraus ergibt sich ein Photonenfluss von ca. 10⁸ Photonen pro Sekunde für die verwendete GaN nanoLED. Der Photonenfluss kann über die angelegte Durchlassspannung geregelt werden.

In Z. Yaun et al., "Electrically driven Single-Photon Source", Science, American Association for the advancement of science, Washington, DC, US, 1. Januar 2002 (2002-01-01), Seiten 102 - 105, XP002278163, ISSN: 0036-8075, DOI: 10.1126/Science.1066790 werden Dioden mit einem intrinsischen Bereich (p-i-n Struktur) als Einzelphotonenquelle beschrieben.

### Aufgabe und Lösung

Es ist daher die Aufgabe der Erfindung, ein Verfahren zur optischen Übertragung einer Struktur in ein Aufnahmemedium zur Verfügung zu stellen, das eine verbesserte Ortsauflösung bietet und zugleich ohne Maskenfertigung auskommt.

Diese Aufgaben werden erfindungsgemäß gelöst durch ein Verfahren gemäß Hauptanspruch. Weitere vorteilhafte Ausgestaltungen ergeben sich aus den darauf rückbezogenen Unteransprüchen.

### Gegenstand der Erfindung

Im Rahmen der Erfindung wurde ein Verfahren zur optischen Übertragung einer Struktur in ein Aufnahmemedium, welches durch Einstrahlung von Photonen aus einer Photonenquelle lokal von einem ersten unbeschriebenen Zustand in einen zweiten beschriebenen Zustand überführbar ist, entwickelt. Dabei manifestieren sich die beiden Zustände des Aufnahmemediums in unterschiedlichen physikalischen und/oder chemischen Eigenschaften des Aufnahmemediums.

Erfindungsgemäß wird für die Einstrahlung der Photonen mindestens eine Photonenquelle mit einem Photonenfluss von weniger als 10⁴ Photonen pro Sekunde gewählt.

Es wurde erkannt, dass mit einem derart geringen Photonenfluss vorteilhaft besonders feine Strukturen in das Aufnahmemedium übertragen werden können, ohne dass die Einstrahlung durch eine Maske teilweise abgeschattet werden muss. Vielmehr stehen für so geringe Photonenflüsse andere Möglichkeiten zur Verfügung, um die in das Aufnahmemedium geschriebenen Strukturen festzulegen: Beispielsweise kann eine Anordnung aus einer Mehrzahl bzw. Vielzahl von Photonenquellen gewählt werden. Sofern diese nicht separat ansteuerbar sind (passive Lithographie), wird die geschriebene Struktur durch die Positionen der Photonenquellen festgelegt; sofern sie separat ansteuerbar sind (aktive Lithographie), wird die geschriebene Struktur zusätzlich über das Ansteuerungsmuster festgelegt. Zusätzlich kann die Photonenquelle bzw. Anordnung aus Photonenquellen relativ zum Aufnahmemedium bewegt, insbesondere gescannt, werden.

Es wurde erkannt, dass die Verwendung einer Maske nach dem bisherigen Stand der Technik mehrere Nachteile mit sich brachte. Diese Nachteile führen in der Summe dazu, dass die in der Praxis erzielbare Ortsauflösung bei der Lithographie regelmäßig deutlich schlechter ist als die Beugungsgrenze von etwa einer halben Lichtwellenlänge.
- Eine Maske besteht in der Regel aus einer lateral strukturierten lichtundurchlässigen Schicht, beispielsweise einer Chrom-Schicht, die die zu schreibende Struktur vorgibt und ihrerseits auf einem lichtdurchlässigen Substrat aufgebracht ist. Dieses muss mindestens ca. 1-2 mm dick sein, um eine ausreichende mechanische Stabilität zu gewährleisten. Die lichtundurchlässige Schicht muss deutlich dicker sein als die optische Eindringtiefe des Lichts, da das Licht vollständig abgeschattet werden muss. Wird ein kleiner Teil des Lichts durchgelassen, wird das Aufnahmemedium an eigentlich nicht zu beschreibenden Stellen mit der Zeit doch umgeschaltet, da es die Wechselwirkungen mit Photonen über die Zeit aufintegriert. Die im Verhältnis zur Lichtwellenlänge und damit zur Strukturgröße deutlich größere Dicke der Maske legt nun den minimalen Abstand zwischen Lichtquelle und Aufnahmemedium fest. Je größer dieser Abstand ist, desto stärker wirken sich die nur endlich scharfen Verteilungen der Energien und Einstrahlrichtungen unter den verwendeten Photonen als Verschmierung der geschriebenen Struktur aus.
- An den Strukturkanten der lichtundurchlässigen Schicht treten weitere Beugungseffekte auf, die ebenfalls zu einer Verschmierung der geschriebenen Struktur führt.
- Die Maske lässt sich nur mit endlicher Präzision fertigen, was zu einer weiteren Unsicherheit bei den genauen Abmessungen der geschriebenen Struktur führt.
- Eine Maske mit makroskopischen Abmessungen, etwa den Abmessungen eines typischen Halbleiterwafers mit mehreren Zoll Durchmesser, wird in der Regel mit einer ausgedehnten Lichtquelle, etwa einer Lampe, bestrahlt. Deren Intensitätsverteilung ist über solche Abmessungen nicht homogen, so dass Strukturen in verschiedenen Bereichen des Aufnahmemediums mit unterschiedlichen Intensitäten geschrieben werden.

Indem nun erfindungsgemäß auf eine Maske verzichtet werden kann, werden diese Fehlerquellen beseitigt, und die erzielbare Auflösung nähert sich der Beugungsgrenze an. Auch fällt die sehr aufwändige und teure Herstellung und Strukturierung der Maske, die nach dem bisherigen Stand der Technik einen Flaschenhals bei der prototypischen Realisierung neuartiger Strukturen bildete, weg.

Um ein Molekül bzw. eine Formeleinheit des Aufnahmemediums vom unbeschriebenen in den beschriebenen Zustand zu überführen, ist mindestens ein Photon als Energiezufuhr erforderlich. Je weniger Photonen angeboten werden, desto weniger Moleküle bzw. Formeleinheiten werden verändert. Vorteilhaft wird die Photonenquelle daher in Arbeitszyklen betrieben, in denen sie zwischen 1 und 100 Photonen emittiert. Wird pro Arbeitszyklus genau ein Photon emittiert, wird die kleinstmögliche Veränderung am Aufnahmemedium vorgenommen.

Wo diese Veränderung genau vorgenommen wird, ist gemäß der Abstrahlcharakteristik der Photonenquelle wahrscheinlichkeitsverteilt. Diese Wahrscheinlichkeitsverteilung geht im Grenzfall großer Photonenzahlen über in das makroskopische Strahlprofil der Photonenquelle. Je größer der Abstand zwischen Photonenquelle und Aufnahmemedium ist, desto mehr ist die Wahrscheinlichkeitsverteilung räumlich aufgeweitet. Vorteilhaft wird daher die Photonenquelle in einen Arbeitsabstand von 1 µm oder weniger zum Aufnahmemedium gebracht. Der minimal mögliche Arbeitsabstand ist im Wesentlichen durch die Oberflächenrauhigkeit und das dadurch bedingte Risiko mechanischer Kollisionen zwischen Photonenquelle und Aufnahmemedium vorgegeben.

In einer besonders vorteilhaften Ausgestaltung der Erfindung werden die Photonenquelle und das Aufnahmemedium relativ zueinander bewegt. Diese Bewegung kann entlang einer Linie erfolgen, die als Struktur in das Aufnahmemedium zu übertragen ist. Sie kann aber auch beispielsweise gerastert erfolgen, wobei die Photonenquelle nur an denjenigen Punkten des Rasters aktiviert wird, an denen gemäß der zu übertragenden Struktur das Aufnahmematerial verändert werden soll.

Dabei sind pro Rasterpunkt die Orte, an denen die ausgesendeten Photonen auf dem Aufnahmemedium auftreffen, wiederum wahrscheinlichkeitsverteilt. Dennoch können Strukturen übertragen werden, die deutlich kleiner sind als die Breite dieser Verteilung. Hierzu wird vorteilhaft ein Aufnahmemedium gewählt, welches erst oberhalb einer vorgegebenen Schwelldosis von Photonen lokal vom unbeschriebenen in den beschriebenen Zustand überführt wird. Durch geeignete Wahl der Rasterweite und der an jedem Rasterpunkt eingestrahlten Photonendosis lässt sich dann eine räumliche Verteilung der insgesamt auf das Aufnahmemedium eingestrahlten Photonendosen erzeugen, die nur entlang der zu übertragenden Struktur oberhalb der Schwelldosis liegt. Dass auch die übrigen Gebiete des Aufnahmemediums Photonen abbekommen haben, fällt für die praktische Anwendung, die nur zwischen den beiden Zuständen "unbeschrieben" und "beschrieben" unterscheidet, nicht mehr ins Gewicht.

Auf diese Weise können mit einer gegebenen Wellenlänge (Energie) der Photonen Strukturen übertragen werden, die deutlich kleiner sind als die durch die Beugungsgrenze vorgegebene Breite der Wahrscheinlichkeitsverteilung für die Orte, an denen die ausgesendeten Photonen auftreffen. Herkömmliche Lithographie ist dagegen beugungsbegrenzt und erfordert kleinere Wellenlängen, um zu kleineren Strukturgrößen überzugehen. Je kleiner die Wellenlänge, desto größer ist der Aufwand, der für die Lichtquelle und die Optik zu treiben ist. Gerade thermische Lichtquellen haben große Unschärfen in den Energien und Richtungen der einzelnen Photonen, aus denen ihr Licht zusammengesetzt ist.

Vorteilhaft wird ein Photoresist für die Photolithographie als Aufnahmemedium gewählt. Dieser kann dort, wo er im beschriebenen Zustand ist (Negativresist), bzw. dort, wo er im unbeschriebenen Zustand ist (Positivresist), selektiv entfernt werden. Das Substrat, auf dem der Photoresist aufgebracht worden war, kann dann durch die solchermaßen strukturierte Maske aus Photoresist hindurch physikalisch oder chemisch bearbeitet werden, beispielsweise durch Ionenätzen oder nasschemisches Ätzen. Auf diese Weise wird die Struktur vom Aufnahmemedium in das Substrat transferiert. Neben einem Photoresist sind beispielsweise auch Phasenwechselmedien und thermisch aktivierte Medien als Aufnahmemedium geeignet.

In einer besonders vorteilhaften Ausgestaltung der Erfindung wird eine Anordnung aus mehreren separat ansteuerbaren Photonenquellen gewählt. Diese können insbesondere in einem Raster mit einer Rasterweite von 100 nm oder weniger, bevorzugt von 50 nm oder weniger, angeordnet sein. Einzelphotonenquellen sind mit Abmessungen bis hinab zu 20 nm verfügbar. Das Raster kann eindimensional, etwa ein Punktraster entlang einer Linie, oder auch zweidimensional, etwa ein gitterförmiges Punktraster, sein. Jede einzelne aktivierte Photonenquelle belegt nun das Aufnahmemedium mit einer räumlichen Wahrscheinlichkeitsverteilung der von ihr ausgesendeten Photonen, wobei sich die Verteilungen, die von benachbarten aktivierten Photonenquellen herrühren, auch überlagern können. Das Aufnahmemedium wird überall dort vom unbeschriebenen in den beschriebenen Zustand überführt, wo in der Summe mindestens der nötige Schwellwert an Photonen eintrifft. Strukturen, deren Abmessungen sich in der Größenordnung des Punktrasters bewegen, können unmittelbar einsichtig in eine Vorschrift abgebildet werden, welche Photonenquellen in dem Raster wie lange bzw. wie häufig zu aktivieren sind. Mit einer physisch gefertigten Anordnung können durch eine Änderung der Ansteuerung eine Vielzahl verschiedener Strukturen geschrieben werden. Eine Anpassung der Struktur erfordert dann keine Anpassung einer hardwaremäßigen Maske mehr, sondern kann durch eine softwaremäßige Änderung der Ansteuerung bewerkstelligt werden.

In einer besonders vorteilhaften Ausgestaltung der Erfindung wird die Häufigkeit und/oder Dauer xᵢ, mit der eine jede Photonenquelle i betrieben wird, als Lösung eines Gleichungssystems bestimmt, in dem die an jedem Ort k auf bzw. in dem Aufnahmemedium eingestrahlte Photonendosis Dₖ als Summe der Beiträge dᵢₖ(xᵢ) ausgedrückt ist, die eine jede Photonenquelle i zu dieser Photonendosis Dₖ leistet. Hierin sind die Dₖ, die auf der rechten Seite stehen, durch die zu übertragende Struktur vorgegeben, wobei das kontinuierliche Aufnahmemedium in individuelle Orte k diskretisiert wurde. Die Beiträge dᵢₖ(xᵢ) hängen von der Abstrahlcharakteristik der Photonenquellen ab. Prinzipiell gibt es immer kleine Abweichungen der tatsächlich geschriebenen Struktur von der vorgegebenen Struktur, da die Wahrscheinlichkeitsverteilungen, an welchen Orten die von jeder Photonenquelle emittierten Photonen auf bzw. in dem Aufnahmemedium eintreffen, nicht notwendigerweise eine zu der zu schreibenden Struktur ähnliche Form aufweisen. Da sich diese Wahrscheinlichkeitsverteilungen jedoch überlappen, können durch Lösen des Gleichungssystems die Beiträge der einzelnen Photonenquellen dahingehend optimiert werden, dass die Abweichungen minimiert werden.

Vorteilhaft werden die Beiträge dᵢₖ(xᵢ) als Produkt von xᵢ mit der Wahrscheinlichkeit pᵢₖ, dass ein individuelles von der Photonenquelle i emittiertes Photon am Ort k auf bzw. in dem Aufnahmemedium eintrifft, ausgedrückt. Das Gleichungssystem wird dann linear. In seinen Koeffizienten stecken die Abstrahlcharakteristik der einzelnen Photonenquellen, ihre räumliche Anordnung und die Feinheit, mit der das Aufnahmemedium in einzelne Orte k diskretisiert wurde.

In einer besonders vorteilhaften Ausgestaltung der Erfindung wird die Anordnung aus Photonenquellen in n verschiedene Positionen relativ zum Aufnahmemedium gebracht. In den Gleichungen des Gleichungssystems wird Dₖ als Summe der Beiträge dᵢₖₚ(xᵢₚ) ausgedrückt, die eine jede Photonenquelle i an der Position p=1,...,n zur Photonendosis Dₖ leistet. Die n Positionen können beispielsweise die Punkte eines Punktrasters sein, das deutlich feiner ist als das Raster der Orte k, an denen die zu erzielenden Photonendosen Dₖ vorgegeben sind. Lösung dieses Gleichungssystems ist ein Satz xᵢₚ, also für jede Photonenquelle i eine genaue Vorschrift, an welchem Ort p diese wie lange bzw. wie häufig zu aktivieren ist. Aus einer vorgegebenen Struktur, die in das Aufnahmemedium zu übertragen ist, wird eine "Lichtshow" der einzelnen Photonenquellen, die abgespielt wird, während die Anordnung der Photonenquellen sukzessive einen Ort p=1,...,n nach dem anderen anfährt.

Auf diese Weise können auch Strukturen übertragen werden, die deutlich kleiner sind als das Raster, in dem die Photonenquellen angeordnet sind. Die Genauigkeit, mit der sich die Anordnung aus Photonenquellen relativ zum Aufnahmemedium verschieben lässt, wird teilweise in Genauigkeit der übertragenen Struktur umgemünzt.

### Spezieller Beschreibungsteil

Nachfolgend wird der Gegenstand der Erfindung anhand von Figuren erläutert, ohne dass der Gegenstand der Erfindung hierdurch beschränkt wird. Es ist gezeigt:
- Figur 1:: Ausführungsbeispiel des erfindungsgemäßen Verfahrens.
- Figur 2:: Schaltschema für die separate Ansteuerung einzelner Photonenquellen in einer Matrix.
- Figur 3:: Elektronenmikroskopische Aufnahmen einer hexagonalen Anordnung aus Photonenquellen.
- Figur 4:: Charakterisierung der Lichtemission aus den in Figur 3 gezeigten Photonenquellen.
- Figur 5:: Pyramidenförmige Einzelphotonenquelle
- Figur 6:: Integration der in Figur 5 gezeigten Einzelphotonenquelle in eine Hochfrequenzstruktur.

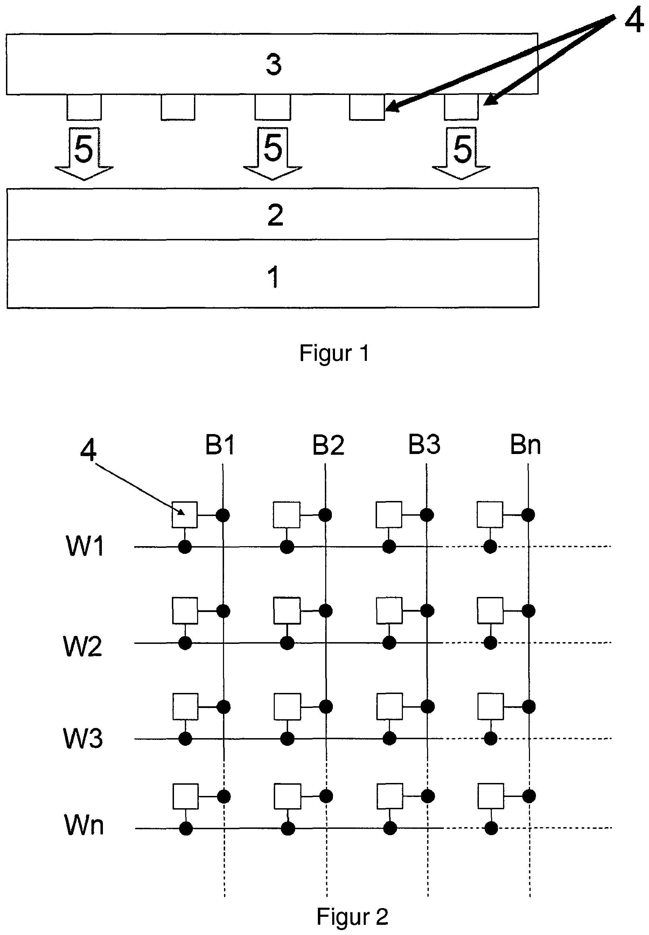

Figur 1 zeigt schematisch ein Ausführungsbeispiel des erfindungsgemäßen Verfahrens. Auf einem Substrat 1 ist das Aufnahmemedium 2, in das eine Struktur zu übertragen ist, aufgebracht. Um die Struktur zu übertragen, wird ein Trägersubstrat 3 mit einer Vielzahl von Einzelphotonenquellen 4 in die Nähe des Aufnahmemediums 2 gebracht. Das Aufnahmemedium 2 wird nun nur im Bereich derjenigen Quellen 4 vom unbeschriebenen in den beschriebenen Zustand umgeschaltet, die aktiviert werden und Licht 5 emittieren. Unterschiedliche Strukturen können somit allein über eine unterschiedliche Ansteuerung geschrieben werden. In einer vereinfachten Form dieses Ausführungsbeispiels sind die Einzelphotonenquellen 4 nicht separat ansteuerbar, sondern sind entweder alle aktiviert oder alle nicht aktiviert. Die geschriebene Struktur ist dann durch die zweidimensionale Anordnung der Quellen 4 in der Ebene des Trägersubstrats 3 vorgegeben.

Figur 2 zeigt ein Schaltschema für die separate Ansteuerung von Quellen 4. Es ist ein Linienraster aus Wordlines W1, W2, ..., Wn und ein zweites Linienraster aus Bitlines B1, B2, ..., Bn vorgesehen. Beide Linienraster zusammen ergeben ein Rechteckgitter. In der gleichen Periodizität wie dieses Rechteckgitter sind die Quellen 4 angeordnet, wobei eine Quelle mit genau einer Wordline und genau einer Bitline verbunden ist. Wird zwischen einer Wordline und einer Bitline eine Spannung angelegt, wird somit genau eine Quelle 4 aktiviert. Dabei müssen die Wordlines und Bitlines nicht in der gleichen Ebene verlaufen und auch nicht in einer Ebene mit den Quellen 4. Handelt es sich bei den Quellen 4 beispielsweise um Leuchtdioden (LEDs), bei denen die Stapelung aus n-Kontakt, pn-Übergang und p-Kontakt in Richtung der Normalen auf die Zeichenebene verläuft, so können beispielsweise die Wordlines unterhalb der n-Kontakte oder in der Ebene der n-Kontakte verlaufen, so dass jede Wordline nur n-Kontakte miteinander verbindet. Die Bitlines können oberhalb der p-Kontakte oder in der Ebene der p-Kontakte verlaufen, so dass jede Bitline nur p-Kontakte miteinander verbindet.

Prinzipiell gibt es in einem solchen cross-bar array zwischen einer Wordline und einer Bitline nicht nur einen Strompfad durch die Quelle 4, die direkt zwischen diese Wordline und diese Bitline geschaltet ist. Neben diesem direkten Pfad gibt es noch weitere parasitäre Pfade durch eine Vielzahl weiterer Quellen 4. Jede Quelle auf einem solchen parasitären Pfad wird jedoch mit einer wesentlich geringeren Spannung beaufschlagt als diejenige Quelle, die direkt zwischen die angesteuerte Wordline und die angesteuerte Bitline geschaltet ist. Die Spannung an den Quellen auf parasitären Pfaden ist geringer als die bandlückenbedingte Mindestspannung, die benötigt wird, um eine LED zum Leuchten anzuregen. Deshalb wird ausschließlich die direkt zwischen die angesteuerte Wordline und die angesteuerte Bitline geschaltete Quelle 4 zum Leuchten angeregt, obwohl es parasitäre Pfade durch weitere Quellen gibt.

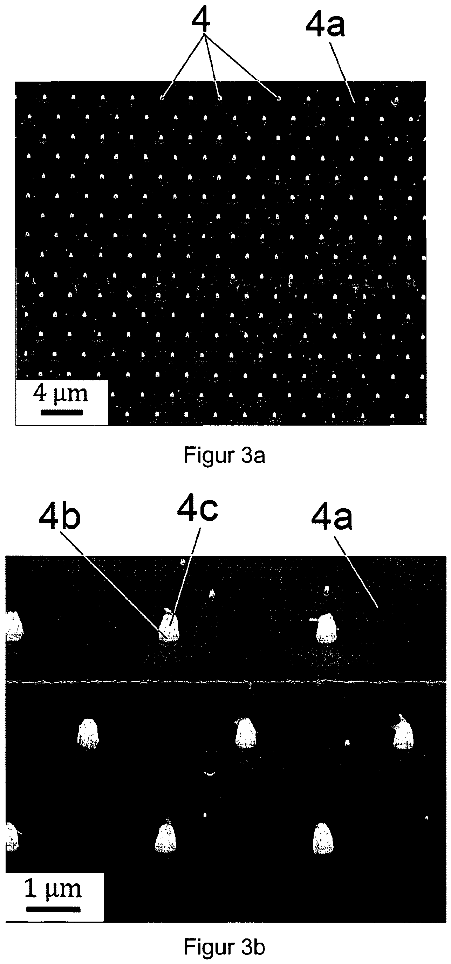

Figur 3 zeigt elektronenmikroskopische Aufnahmen einer hexagonalen Anordnung aus Quellen 4. Teilbild b ist eine Zoom-Aufnahme eines Teilbereichs von Teilbild a. Die Quellen 4 sind LED-Strukturen, deren gemeinsame n-Region die in Figur 3 dunkel dargestellte n-dotierte GaN-Schicht 4a auf einem Saphir-Substrat ist. Auf der n-dotierten GaN-Schicht 4a sind geätzte Säulen aus einer undotierten GaInN/GaN-Multilagenstruktur 4b, die jeweils einen Multiquantumweil (MQW) bilden. Der MQW fungiert als aktives Medium, das die Wellenlänge der Photonenquelle bestimmt. Auf einem jeden MQW ist p-dotiertes GaN als p-Region 4c aufgewachsen.

Die Anordnung wurde hergestellt, indem die Multilagenstruktur 4b und die p-Region 4c zunächst als flächige Schichten auf die GaN-Schicht 4a aufgebracht wurden. Anschließend wurde Photoresist mit Elektronenstrahllithographie so strukturiert, dass überall dort, wo eine Quelle 4 als Säule stehenbleiben sollte, die p-Region 4c freigelegt wurde. Es wurde eine Nickel-Schicht aufgebracht und anschließend der Photoresist durch Lift-Off entfernt, so dass Nickel 4d nur auf den p-Regionen 4c verblieb und ansonsten entfernt wurde. Die Multilagenstruktur 4b und die p-Region 4c wurden überall dort, wo sie nicht durch das Nickel geschützt wurden, bis hinab zur GaN-Schicht 4a weggeätzt.

In dem in Figur 3 dargestellten Stadium fehlt der Anordnung noch die elektrische Kontaktierung der p-Regionen 4c mit der Außenwelt. Diese lässt sich herstellen, indem ein isolierendes Material zwischen die Säulen eingebracht wird bis auf eine solche Höhe, dass nur noch die Regionen 4c und 4d herausragen. Als ein solches Isoliermaterial eignet sich beispielsweise Wasserstoffsilsesquioxan (HSQ), das auf die Anordnung aufgeschleudert werden kann und unter Einwirkung von Hitze isolierendes SiO₂ als Endprodukt bildet. Wenn die SiO₂-Schicht gebildet ist, wird das Nickel selektiv entfernt und hierauf eine transparente, elektrisch leitende Kontaktschicht aus einer Nickel-Gold-Legierung aufgebracht, die die gewünschten Regionen 4c mit der Außenwelt verbindet. n-Kontakte entstehen durch Ar-Ionenstrahl-Ätzen des SiO₂ bis in die n-GaN Schicht hinein in den Regionen, die vorher mit lithographischen Verfahren definiert worden sind. Anschließend wird eine Metallisierung mit Ti/Al/Ni/Au Schichten durchgeführt, die danach einlegiert werden.

Die Anordnung lässt sich auch so ausgestalten, dass die Quellen 4 individuell adressierbar werden. Dazu wird die GaN-Schicht 4a in Form von Wordlines strukturiert, die jeweils eine Zeile von Säulen miteinander verbinden. Jede Säule steht dann jeweils auf genau einer Wordline, und zwischen den Wordlines ist die GaN-Schicht 4a bis hinab zum Saphir-Substrat entfernt, so dass die Wordlines gegeneinander isoliert sind. Die transparente, elektrisch leitende Kontaktschicht wird lateral in Form von Bitlines strukturiert, die jeweils Spalten von Regionen 4c miteinander und mit der Außenwelt verbinden. Durch Anlegen einer Spannung zwischen eine Wordline und eine Bitline kann dann genau eine Quelle 4 aktiviert werden.

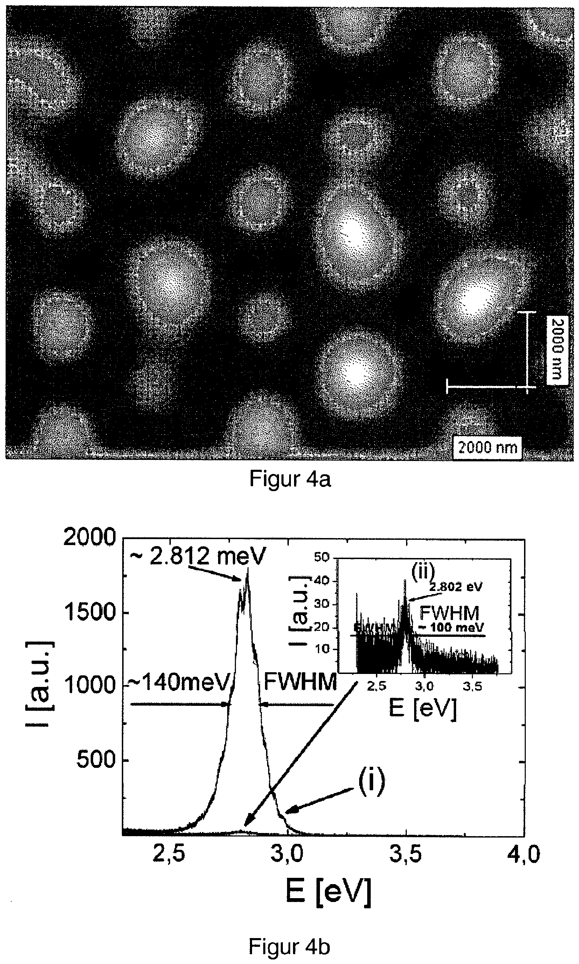

Figur 4a zeigt die räumliche Verteilung der Photolumineszenz, die das in Figur 3 dargestellte Schichtsystem auf eine optische Anregung mit einer Lichtwellenlänge von 325 nm emittiert hat. Die Photolumineszenz fand bei einer Wellenlänge von 440 nm statt. Die Messung der Photolumineszenz eignet sich als Zwischentest für die Qualitätskontrolle bei der Fertigung. Zeigt sich keine Photolumineszenz, handelt es sich bei der hergestellten Anordnung um Ausschuss, und die weiteren Prozessschritte erübrigen sich.

Figur 4b zeigt die Intensitätsverteilung I der Elektrolumineszenz über der Energie E für den flächigen Schichtstapel, aus dem die in Figur 3 gezeigte Anordnung hergestellt wurde (vor dem Aufbringen des Photoresists; Kurve (i)), sowie für eine einzelne Quelle 4 (Kurve (ii)). Die Verteilung hat für die Kurve (i) eine Halbwertsbreite (FWHM) von 140 meV, für die Kurve (ii) hat sie eine Halbwertsbreite von 100 meV. Indem die räumliche Dimension der Quelle 4 von der flächigen Schicht auf die Säule verkleinert wurde, wurde die Anzahl der emittierten Photonen pro Zeiteinheit so weit vermindert, dass bei genügend kurzer Pulsdauer die Emission einzelner Photonen angeregt werden kann. Je kleiner die geätzte Säule ist, desto höher ist das Quantum Confinement in den Säulen und desto schmaler ist der Bereich der Photonenenergien, die eine einzelne Photonenquelle emittiert.

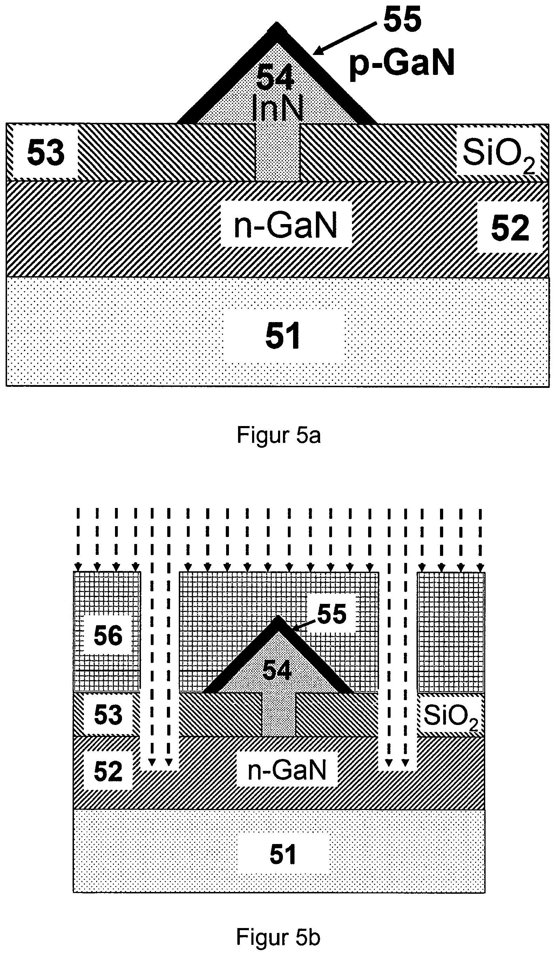

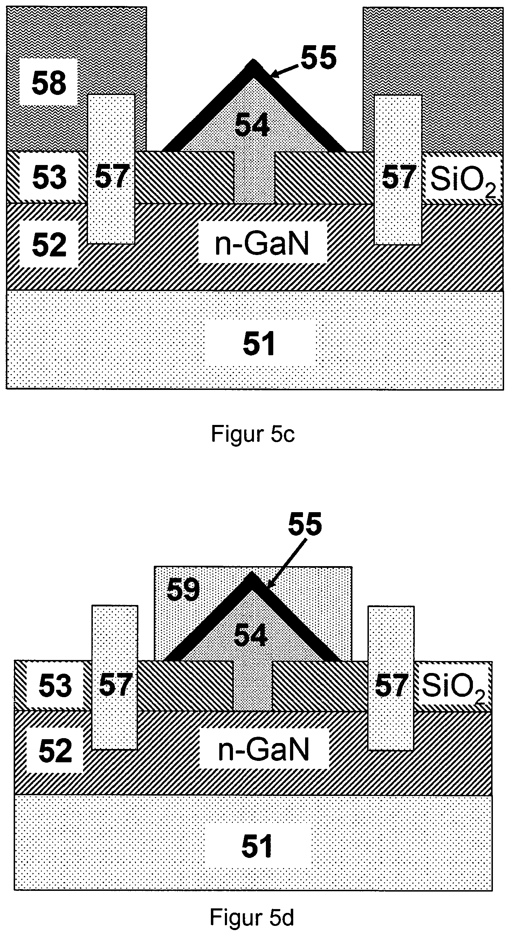

Figur 5 zeigt ein weiteres Realisierungsbeispiel für eine Einzelphotonenquelle 4, die sich zur Durchführung des erfindungsgemäßen Verfahrens eignet. Auf ein Saphir-Substrat 51 wird zunächst durch einen MOVPE-Prozess eine n-dotierte GaN-Schicht 52 aufgebracht. Hierauf wird eine HSQ-Schicht 53 aufgeschleudert, die unter Einwirkung von Hitze isolierendes SiO₂ als Endprodukt bildet. Ein Polymer Polymethylmethacrylat PMMA wird aufgebracht und dient als Positivresist für die Elektronenstrahllithographie. Die Schicht wird dort, wo die Einzelphotonenquelle 4 entstehen soll, mit einem Elektronenstrahl belichtet und anschließend selektiv entfernt. Das offengelegte SiO₂ wird mittels reaktivem Ionenätzen entfernt. Anschließend wird dann das PMMA entfernt. SiO₂ ist nicht nur ein isolierendes Material, sondern dient als Maske für die nachfolgende Epitaxie. Durch einen weiteren MOVPE-Prozess wird InN selektiv durch die in der HSQ-Schicht entstandene Öffnung auf das n-GaN aufgebracht. Das InN wächst als Pyramide 54 aus der SiO₂ Maske heraus. Die Pyramide wird konformal mit p-dotiertem GaN 55 überwachsen. Dabei wird zwischen dem p-dotierten GaN, dem undotierten InN und dem n-dotierten GaN der p i n-Übergang der LED gebildet (Figur 5a).

Es wird eine Photoresist-Schicht 56 aufgebracht und lithographisch so strukturiert, dass links und rechts der Pyramide 54/55 jeweils Bereiche entstehen, in denen die SiO₂-Schicht 53 freigelegt wird. In diesen Bereichen werden durch das mit gestrichelten Pfeilen angedeutete Argon-Ionenätzen die SiO₂-Schicht 53 und ein oberflächen naher Bereich der n-GaN-Schicht 52 weggeätzt (Figur 5b). Anschließend werden die Metalle Ti/Al/Ni/Au aufgebracht, die in diesen Bereichen nach dem Einlegieren metallische Kontakte 57 bilden, die die n-GaN-Schicht mit der Außenwelt verbinden. Das restliche Metall wird durch Lift-Off der Photoresist-Schicht 56 entfernt. Eine weitere Photoresist-Schicht 58 wird aufgebracht und lateral so strukturiert, dass die Pyramide 54 freigelegt wird (Figur 5c).

Es wird erneut Metall aufgebracht - hier Ni und Au, das die Pyramide 54/55 umschließt. Durch einen erneuten Lift-Off wird das auf der Photoresist-Schicht 58 abgelagerte Metall entfernt. Es verbleibt ein metallischer Kontakt 59, über den die -Pyramide 54/55 angesteuert werden kann. Die Photonenquelle wird aktiviert, wenn zwischen den Kontakten 57 und 59 eine Spannung angelegt wird.

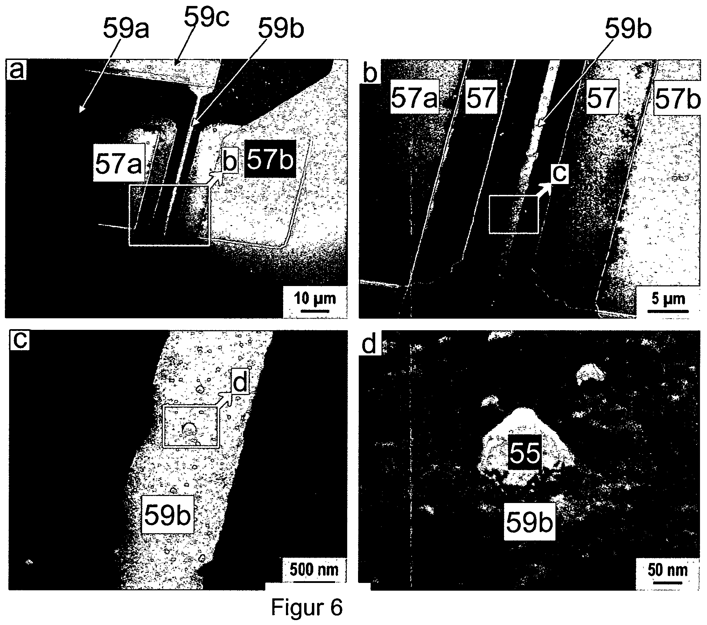

Figur 6 zeigt elektronenmikroskopische Aufnahmen einer auf diese Weise hergestellten Einzelphotonenquelle, die in eine Hochfrequenz-Struktur integriert ist. Die Teilbilder a-d zeigen verschiedene Vergrößerungsstufen. Der Kontakt 59 ist hier als Metallzunge 59a, 59b ausgebildet, die die noch sichtbare, p-GaN ummantelte InN-Pyramide 54/55 bedeckt. Jeweils zwei dieser Zungen münden in ein makroskopisches Kontaktpad 59c zur elektrischen Verschaltung der Pyramide 54/55 mit der Außenwelt. Die Kontakte 57 münden ebenfalls in makroskopische Kontaktpads 57a, 57b zur Verschaltung der n-GaN-Schicht mit der Außenwelt. Wird eine Spannung zwischen den Kontaktpads 59c und 57a angelegt, wird die Quelle auf der Metallzunge 59a aktiviert.

## Patentansprüche

1. Verfahren zur optischen Übertragung einer Struktur in ein Aufnahmemedium, welches durch Einstrahlung von Photonen aus einer Photonenquelle lokal von einem ersten unbeschriebenen Zustand in einen zweiten beschriebenen Zustand überführbar ist, wobei sich die beiden Zustände des Aufnahmemediums in unterschiedlichen physikalischen und/oder chemischen Eigenschaften des Aufnahmemediums manifestieren,
**dadurch gekennzeichnet, dass**
für die Einstrahlung der Photonen mindestens eine Photonenquelle mit einem Photonenfluss von weniger als 10⁴ Photonen pro Sekunde gewählt wird.

2. Verfahren nach Anspruch 1, **dadurch gekennzeichnet, dass** die Photonenquelle in Arbeitszyklen betrieben wird, in denen sie zwischen 1 und 100 Photonen emittiert.

3. Verfahren nach einem der Ansprüche 1 bis 2, **dadurch gekennzeichnet, dass** die Photonenquelle in einen Arbeitsabstand von 1 µm oder weniger zum Aufnahmemedium gebracht wird.

4. Verfahren nach einem der Ansprüche 1 bis 3, **dadurch gekennzeichnet, dass** die Photonenquelle und das Aufnahmemedium relativ zueinander bewegt werden.

5. Verfahren nach einem der Ansprüche 1 bis 4, **dadurch gekennzeichnet, dass** ein Aufnahmemedium gewählt wird, welches erst oberhalb einer vorgegebenen Schwelldosis von Photonen lokal vom unbeschriebenen in den beschriebenen Zustand überführt wird.

6. Verfahren nach einem der Ansprüche 1 bis 5, **dadurch gekennzeichnet, dass** ein Photoresist für die Photolithographie als Aufnahmemedium gewählt wird.

7. Verfahren nach einem der Ansprüche 1 bis 6, **dadurch gekennzeichnet, dass** eine Anordnung aus mehreren separat ansteuerbaren Photonenquellen gewählt wird.

8. Verfahren nach Anspruch 7, **dadurch gekennzeichnet, dass** die Photonenquellen in einem Raster mit einer Rasterweite von 100 nm oder weniger, bevorzugt von 50 nm oder weniger, angeordnet sind.

9. Verfahren nach einem der Ansprüche 7 bis 8, **dadurch gekennzeichnet, dass** die Häufigkeit und/oder Dauer xᵢ, mit der eine jede Photonenquelle i betrieben wird, als Lösung eines Gleichungssystems bestimmt wird, in dem die an jedem Ort k auf bzw. in dem Aufnahmemedium eingestrahlte Photonendosis Dₖ als Summe der Beiträge dᵢₖ(xᵢ) ausgedrückt ist, die eine jede Photonenquelle i zu dieser Photonendosis Dₖ leistet.

10. Verfahren nach Anspruch 9, **dadurch gekennzeichnet, dass** in dem Gleichungssystem die Beiträge dᵢₖ(xᵢ) als Produkt von xᵢ mit der Wahrscheinlichkeit pᵢₖ, dass ein individuelles von der Photonenquelle i emittiertes Photon am Ort k auf bzw. in dem Aufnahmemedium eintrifft, ausgedrückt sind.

11. Verfahren nach einem der Ansprüche 9 bis 10, **dadurch gekennzeichnet, dass** die Anordnung aus Photonenquellen in n verschiedene Positionen relativ zum Aufnahmemedium gebracht wird und dass Dₖ als Summe der Beiträge dᵢₖₚ(xᵢₚ) ausgedrückt wird, die eine jede Photonenquelle i an der Position p=1,...,n zur Photonendosis Dₖ leistet.

## Claims

1. Method for optical transmission of a structure into a recording medium, which may be converted locally from a first undescribed state into a second described state through irradiation by photons from a photon source, in which both states of the recording medium manifest themselves in different physical and/or chemical properties of the recording medium,
**characterised in that**
at least one photon source with a photon flow of less than 10⁴ photons per second is selected for irradiation by photons.

2. Method according to claim 1, **characterised in that** the photon source is operated in working cycles, in which it emits between 1 and 100 photons.

3. Method according to one of claims 1 to 2, **characterised in that** the photon source is brought into a working distance of 1 µm or less to the recording medium.

4. Method according to one of claims 1 to 3, **characterised in that** the photon source and the recording medium are moved in relation to one another.

5. Method according to one of claims 1 to 4, **characterised in that** a recording medium is selected, which first is converted locally from the undescribed to the described state above a preset threshold dose of photons.

6. Method according to one of claims 1 to 5, **characterised in that** a photo resist for photolithography is selected as recording medium.

7. Method according to one of claims 1 to 6, **characterised in that** an arrangement of several separately controllable photon sources is selected.

8. Method according to claim 7, **characterised in that** the photon sources are arranged in a screen with a screen width of 100 nm or less, preferably 50 nm or less.

9. Method according to one of claims 7 to 8, **characterised in that** the frequency and/or duration xᵢ, with which each photon source i is operated, is determined as the solution of an equation system, in which the photon dose Dₖ irradiated at each location k on or in the recording medium is expressed as a total of the contributions dᵢₖ(Xᵢ), which each photon source i provides at this photon dose Dₖ.

10. Method according to claim 9, **characterised in that** in the equation system the contributions dᵢₖ(xᵢ) are expressed as a product of xᵢ with the probability pᵢₖ that an individual photon emitted by the photon source i arrives at the location k on or in the recording medium.

11. Method according to one of claims 9 to 10, **characterised in that** the arrangement of photon sources is brought into n different positions in relation to the recording medium and that Dₖ is expressed as a total of the contributions dᵢₖₚ(Xᵢₚ), which each photon source i provides at position p=1,...,n at the photon dose Dₖ.

## Revendications

1. Procédé de transfert optique d'une structure dans un support d'enregistrement qui, par irradiation de photons provenant d'une source de photons, peut être transformé localement d'un premier état non décrit en un second état décrit, dans lequel les deux états du support d'enregistrement se manifestent dans différentes propriétés physiques et/ou chimiques du support d'enregistrement,
**caractérisé en ce que**
au moins une source de photons avec un flux de photons de moins de 10⁴ photons par seconde est choisie pour l'irradiation des photons.

2. Procédé selon la revendication 1, **caractérisé en ce que** la source de photons fonctionne en cycles de travail dans lesquels elle émet entre 1 et 100 photons.

3. Procédé selon l'une des revendications 1 à 2, **caractérisé en ce que** la source de photons est amenée à une distance de travail de 1 µm ou moins par rapport au support d'enregistrement.

4. Procédé selon l'une des revendications 1 à 3, **caractérisé en ce que** la source de photons et le support d'enregistrement sont déplacés l'un par rapport à l'autre.

5. Procédé selon l'une des revendications 1 à 4, **caractérisé en ce qu'**est choisi un support d'enregistrement qui n'est transformé localement de l'état non décrit à l'état décrit qu'au-delà d'une dose de seuil prescrite de photons.

6. Procédé selon l'une des revendications 1 à 5, **caractérisé en ce qu'**est choisie comme support d'enregistrement une laque photosensible pour la photolithographie.

7. Procédé selon l'une des revendications 1 à 6, **caractérisé en ce qu'**est choisi un agencement de plusieurs sources de photons contrôlables séparément.

8. Procédé selon la revendication 7, **caractérisé en ce que** les sources de photons sont disposées en une trame avec un espacement de trame de 100 nm ou moins, de préférence de 50 nm ou moins.

9. Procédé selon l'une des revendications 7 à 8, **caractérisé en ce que** la fréquence et/ou la durée xᵢ à laquelle/pendant laquelle chaque source de photons i fonctionne est déterminée en tant que solution d'un système d'équations dans lequel la dose de photons Dₖ irradiée à chaque emplacement k sur ou dans le support d'enregistrement est exprimée en tant que somme des contributions dᵢₖ(xᵢ) que chaque source de photons i apporte à cette dose de photons Dₖ.

10. Procédé selon la revendication 9, **caractérisé en ce que** dans le système d'équations, les contributions dᵢₖ(xᵢ) sont exprimées en tant que produit de xᵢ avec la probabilité Pᵢₖ pour qu'un photon individuel émis par la source de photons i arrive à l'emplacement k sur ou dans le support d'enregistrement.

11. Procédé selon l'une des revendications 9 à 10, **caractérisé en ce que** l'agencement de sources de photons est amené en n diverses positions par rapport au support d'enregistrement et **en ce que** Dₖ est exprimée en tant que somme des contributions dᵢₖₚ(xᵢₚ) que chaque source de photons i à la position p=1,...,n apporte à la dose de photons Dₖ.
